# EUROPÄISCHE PATENTSCHRIFT

(11) **EP 0 418 508 B1**
(45) Veröffentlichungstag und Bekanntmachung des Hinweises auf die Patenterteilung: **06.10.1993**
(21) Anmeldenummer: 90114276.0
(22) Anmeldetag: 25.07.1990
(51) Int. Cl.: H01R 13/405, H01R 23/68, H01R 9/07

(54) **Elektrischer Steckverbinder**
Electrical connector
Connecteur électrique

(30) Priorität: 28.07.1989 DE 3925155
(43) Veröffentlichungstag der Anmeldung: 27.03.1991
(73) Patentinhaber: Siemens Nixdorf Informationssysteme Aktiengesellschaft, 33102 Paderborn (DE)
(72) Erfinder: Klimke, Peter, Dipl. Ing., D-8000 München 90 (DE); Bergmiller, Ludwig, Dipl. Ing., D-8900 Augsburg 21 (DE)
(74) Vertreter: Fuchs, Franz-Josef, Dr.-Ing.

(56) Entgegenhaltungen:
- DE-B- 2 619 152
- US-A- 3 888 639

## Beschreibung

Die Erfindung betrifft einen Steckverbinder und die Herstellung desselben.

DE-B-2 619 152 beschreibt einen hülsenformigen Rundstecker, der in einen Durchgang einer Leiterplatte eingesteckt und von der anderen Seite der Leiterplatte durch eine Klemmbuchse festgehalten wird, wobei ein an die Hülse des Steckers anschließender Umfangstwulst an einem Stirnbund des Durchgangs anliegt. Durch Löten wird der Stecker mit der Leiterbahn der Leiterplatte elektrisch verbunden.

Aus konstruktiven Gründen ist es oft bei verschiedenen Steckverbindern wegen der hohen Kosten nicht mehr möglich, die Stekkerstifte oder Lötfahnen von Steckern im Schwallötverfahren einzulöten.

Aufgabe der vorliegenden Erfindung ist es, einen Steckverbinder zu schaffen, bei dem sämtliche Kontakte ohne zusätzliche Schutzmaßnahmen gegen Verunreinigungen in einem einzigen Lötschritt befestigt werden können. Eine weitere Aufgabe ist es, ein Verfahren zum Einsetzen der Stifte oder Lötfahnen anzugeben.

Zur Lösung dieser Aufgabe wird gemäß der Erfindung der Steckverbinder zur Herstellung elektrischer Verbindungen, insbesondere bei Geräten der Datentechnik, derart ausgebildet, daß an einem Ende einer flexiblen Leiterfolie zwei aufeinanderliegende Versteifungsleisten aus Kunststoff, z.B. faserverstärktem Epoxidharz, auflaminiert sind, daß die unmittelbar auf der Leiterfolie aufliegende erste Leiste durchkontaktierte und mit Lötaugen versehene Bohrungen und die zweite auf der ersten aufliegende Leiste an den gleichen Stellen, an denen bei der ersten Leiste Bohrungen vorgesehen sind, Aussparungen aufweist, die gleich oder größer als der Durchmesser der Lötaugen auf der ersten Leiste sind, daß in den Bohrungen die Enden von Kontakten befestigt sind, und daß auf der gegenüberliegenden Seite der Leiterfolie die auf ihr befindlichen Leiterbahnen zur Kontaktierung freigelegt sind.

Durch diese Maßnahmen erhält man einen Steckverbinder, der oberflächemontierbar, qualitativ hochwertig und gleichzeitig kostengünstig herstellbar ist.

Die in den Bohrungen befestigten Kontakte können Stifte oder Lötfahnen sein.

Die Stifte können an ihrem einen Ende auch Köpfe aufweisen, welche in den Aussparungen der zweiten Leiterplatte liegen, wobei der Durchmesser der Bohrungen der ersten Leiterplatte grösser ist als der Durchmesser der Stifte, aber kleiner als der Durchmesser der Köpfe.

Dadurch wird nach dem Durchstecken der Stifte durch den Kopf ein Anschlag an der ersten Leiterplatte erzielt, durch den ein kompliziertes Verfahren zur Ausrichtung der Stifte entfallen kann.

Gemäß einer weiteren Aufgabe der Erfindung werden die Stifte oder Lötfahnen derart eingesetzt, daß zuerst die Aussparungen der zweiten Leiterplatte mit Lötzinn in Form von Lötpaste beaufschlagt, anschließend die Stifte oder Lötfahnen von der Seite der zweiten Leiterplatte durch die Aussparungen in die Bohrungen der ersten Leiterplatte eingesetzt und durch Wiederaufschmelzen des Lötzinns in den Aussparungen festgelötet werden.

Verunreinigungen durch das beim Löten sonst verwendete Colophonium für die Stiftkontakte ist dabei reduziert.

Ein weiteres Verfahren sieht vor, daß die Stifte von der Seite der zweiten Leiterplatte soweit in die Bohrungen der ersten Leiterplatte eingeschoben werden, bis die Köpfe in den Aussparungen einen Anschlag finden, daß anschließend Lötpaste in den Aussparungen aufgetragen und mittels Wiederaufschmelzen des Lötzinns die Stifte festgelötet werden.

Diese Verfahren sind für die automatische Fertigung besonders günstig geeignet und einfach in ihrer Handhabung.

Anhand der Ausführungsbeispiele nach den FIG 1 bis 6 wird die Erfindung näher erläutert. Es zeigen
FIG 1 die Draufsicht auf einen Steckverbinder,
FIG 2 den Schnitt I-I durch einen Steckverbinder,
FIG 3 eine Einzelheit III nach FIG 2,
FIG 4 das Detail eines Schnitts senkrecht zur Zeichenebene im Bereich einer Bohrung an dem versteiften Ende der Leiterfolie,
FIG 5 den gleichen Schnitt nach FIG 4 nach Einsetzen eines Stiftkontaktes ohne Kopf,
FIG 6 den gleichen Schnitt nach FIG 4 nach Einsetzen eines Stiftkontaktes mit Kopf.

Der Steckverbinder besteht aus einer Leiterfolie 1, auf derem oberen Ende, z.B. aus faserverstärktem Epoxidharz bestehende Versteifungsleisten 2, 3 auflaminiert sind. Am anderen Ende der Leiterfolie 1 ist ebenfalls ein versteifender Bügel 4 auflaminiert, der bei einem montierten Steckverbinder zur Zugentlastung dient. In der Aussparung dieses Bügels 4 sind zum oberflächenmontierbaren Anschluß geeignete Kontakte 5 ersichtlich.

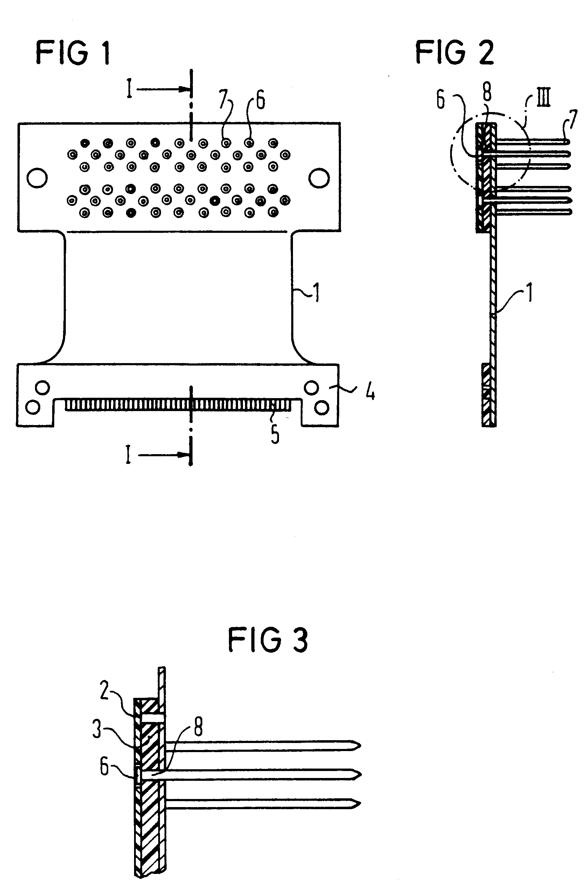

Die erste Versteifungsleiste 3 ist wie aus dem Querschnitt durch den Steckverbinder nach FIG 1, in FIG 2 ersichtlich, unmittelbar auf die Leiterfolie 1 aufgebracht, wobei diese Versteifungsleiste durchkontaktierte Bohrungen 8 enthält, in die die Stifte 7 eingelötet werden. Die zweite Versteifungsleiste 2 ist unmittelbar auf die erste Versteifungsleiste 3 aufgebracht, und sie enthält in dem Bereich, in dem in der ersten Versteifungsleiste 3 durchkontaktierte Bohrungen vorgesehen sind, Aussparungen 6, die einen größeren Durchmesser haben als die Bohrungen 8, wobei diese Aussparungen mindestens so groß sind, als die Lötaugen 9, die sich um die Bohrungen 8 in der ersten Versteifungsleiste 3 befinden.

In FIG 3 ist ein Detailausschnitt III nach FIG 2 dargestellt, wobei die Aussparungen 6 und die durchkontaktierten Bohrungen 8 im vergrößerten Maßstab nocheinmal deutlicher ersichtlich sind.

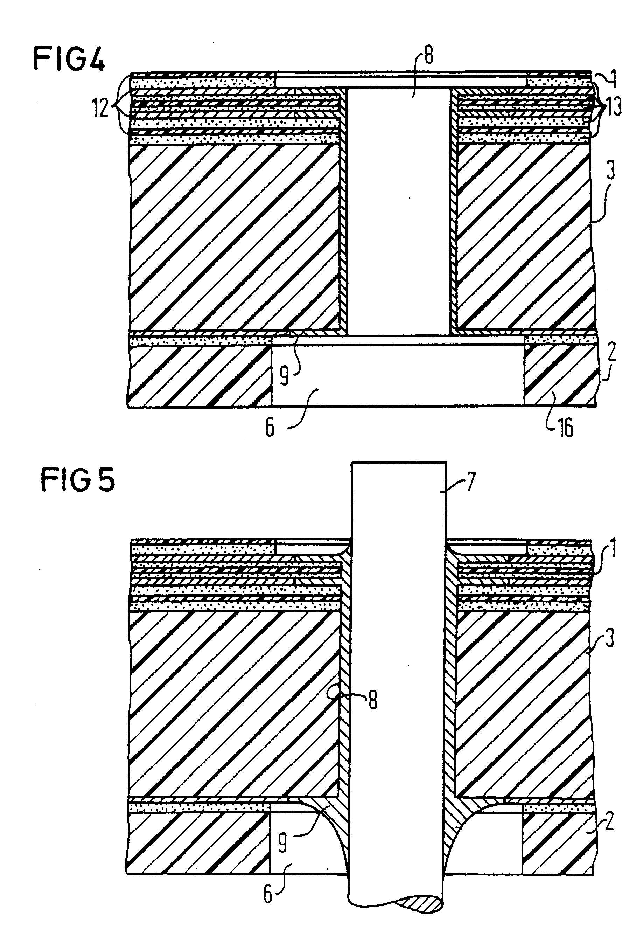

Einen Querschnitt senkrecht zur Zeichenebene und senkrecht zum Schnitt I-I ist in einem Detailbereich in FIG 4 dargestellt, wobei die flexible Leiterfolie 1 in ihrer mehrfachlagigen Strukturierung zwischen Ebenen die Leiterbahnen 12 tragen und entsprechend dazwischenliegenden, aus Isolationsmaterial bestehenden Ebenen 13 dargestellt sind. Die einzelnen Ebenen sind jeweils mittels einer Klebeschicht miteinander verklebt. Im Anschluß an die flexible Leiterfolie 1 liegt die erste Versteifungsleiste 3, die ebenso wie die Leiterfolie 1 durchkontaktierte Bohrungen 8 aufweist, sowie die sich an der Unterseite befindlichen Lötaugen 9 und unmittelbar unterhalb dieser ersten Versteifungsleiste 3 liegt die zweite Versteifungsleiste 2, die im gezeichneten Falle lediglich eine einzige Leiterlage 16 aufweist. Die zweite Versteifungsleiste 2 hat Aussparungen 6 in der Abmessung, wie bereits vorstehend beschrieben.

Bei Kontakten, die als Stifte 7 ausgebildet sind, und keinen Kopf an einem ihrer Enden tragen, wird die Aussparung zuerst mit einer Lötpaste bedruckt. Die Stifte oder Lötfahnen werden von der Seite mit den Aussparungen 6 eingesetzt und anschließend durch ein Wiederaufschmelzverfahren in den durchkontaktierten Bohrungen 8 festgelötet.

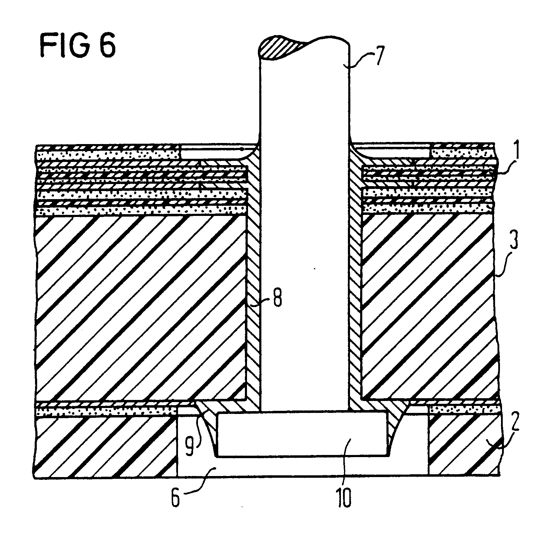

Stifte 7, die an ihrem einen Ende einen Kopf 10 tragen, werden, wie in FIG 6 dargestellt, ebenfalls von der Seite der zweiten Versteifungsleiste 2 durch die Aussparungen 10 in die Bohrungen 8 der ersten Versteifungsleiste 3 soweit eingeschoben, bis die Köpfe 10 der Stifte 7 an dieser ersten Versteifungsleiste 3 einen Anschlag finden, so daß dann der Kopf in den Aussparungen 6 auf den Lötaugen 9 der ersten Versteifungsleiste 3 aufliegt. Anschließend werden die Aussparungen 6 mit Lötpaste bedruckt und dann ebenfalls eine Festlötung der Stifte 7 mit Hilfe eines Wiederaufschmelzverfahrens bewerkstelligt.

## Patentansprüche

1. Steckverbinder zur Herstellung elektrischer Verbindungen, insbesondere bei Geräten der Datentechnik, wobei an einem Ende einer flexiblen Leiterfolie (1) zwei aufeinanderliegende Versteifungsleisten (2,3) aus Kunststoff, z.B. faserverstärktem Epoxidharz auflaminiert sind, wobei die unmittelbar auf der Leiterfolie (1) aufliegende erste Leiste (3) durchkontaktierte und mit Lötaugen (9) versehene Bohrungen (8) und die zweite auf der ersten aufliegende Leiste an den gleichen Stellen, an denen bei der ersten Leiste Bohrungen vorgesehen sind, Aussparungen (6) aufweist, die gleich oder größer als der Durchmesser der Lötaugen (9) auf der ersten Leiste (3) sind, wobei in den Bohrungen (8) die Enden von Kontakten befestigt sind, und wobei auf der gegenüberliegenden Seite der Leiterfolie (1) die auf ihr befindlichen Leiterbahnen (13) zur Kontaktierung freigelegt sind.

2. Steckverbinder zur Herstellung elektrischer Verbindungen nach Anspruch 1, **dadurch gekennzeichnet,** daß die in den Bohrungen (8) befestigten Kontakte Stifte (7) oder Lötfahnen sind.

3. Steckverbinder zur Herstellung elektrischer Verbindungen nach Anspruch 2, **dadurch gekennzeichnet,** daß die Stifte (7) an ihrem einen Ende Köpfe (10) aufweisen, welche in den Aussparungen (6) der zweiten Leiterplatte (2) liegen und daß der Durchmesser der Bohrungen (8) der ersten Leiterplatte (3) größer ist als der Durchmesser der Stifte (7) aber kleiner als der Durchmesser der Köpfe (10).

4. Verfahren zum Einsetzen der Stifte oder Lötfahnen des Stecksverbinders nach Anspruch 2, **dadurch gekennzeichnet,** daß zuerst die Aussparungen (6) der zweiten Leiterplatte (2) mit Lötzinn in Form von Lötpaste beaufschlagt, anschließend die Stifte (7) oder Lötfahnen von der Seite der zweiten Leiterplatte (2) durch die Aussparungen (6) in die Bohrungen (8) der ersten Leiterplatte (3) eingesetzt und durch Wiederaufschmelzen des Lötzinns in den Aussparungen (6) festgelötet werden.

5. Verfahren zum Einsetzen der Stifte des Steckverbinders nach Anspruch 3, **dadurch** **gekennzeichnet**, daß die Stifte (7) von der Seite der zweiten Leiterplatte (2) soweit in die Bohrungen (8) der ersten Leiterplatte (3) eingeschoben werden, bis die Köpfe (10) in den Aussparungen (6) einen Anschlag finden, daß anschließend Lötpaste in den Aussparungen (6) aufgetragen und mittels Wiederaufschmelzen des Lötzinns die Stifte (7) festgelötet werden.

## Claims

1. Plug connector for producing electrical connections, preferably in the case of apparatuses for data technology, two reinforcing strips (2, 3) which rest on one another and consist of plastic, for example fibre-reinforced epoxy resin, being laminated on at one end of a flexible conductor foil (1), holes (8) being provided which make through-plated contact with the first strip (3) which rests directly on the conductor foil (1), and are provided with solder eyes (9), and the second strip, which rests on the first strip, having recesses (6) at the same points at which holes are provided in the case of the first strip, which recesses (6) are equal to or larger than the diameter of the solder eyes (9) on the first strip (3), the ends of the contacts being mounted in the holes (8), and, on the opposite side of the conductor foil (1), the conductor tracks (13) which are located thereon being exposed in order to make contact.

2. Plug connector for producing electrical connections according to Claim 1, characterised in that the contacts which are mounted in the holes (8) are pins (7) or solder tabs.

3. Plug connector for producing electrical connections according to Claim 2, characterised in that the pins (7) have heads (10) at the one end, which heads (10) lie in the recesses (6) of the second printed-circuit board (2), and in that the diameter of the holes (8) in the first printed-circuit board (3) is larger than the diameter of the pins (7) but smaller than the diameter of the heads (10).

4. Method for inserting the pins or solder tabs of the plug connector according to Claim 2, characterised in that, first of all, the recesses (6) in the second printed-circuit board (2) have solder tin applied to them in the form of solder paste, the pins (7) or solder tabs are subsequently inserted from the side of the second printed-circuit board (2) through the recesses (6) into the holes (8) in the first printed-circuit board (3) and are firmly soldered in the recesses (6) by remelting the solder tin.

5. Method for inserting the pins of the plug connector according to Claim 3, characterised in that the pins (7) are pushed from the side of the second printed-circuit board (2) so far into the holes (8) in the first printed-circuit board (3) that the heads (10) find a stop in the recesses (6), in that solder paste is subsequently deposited in the recesses (6) and the pins (7) are firmly soldered by remelting the solder tin.

## Revendications

1. Connecteur pour l'établissement de liaisons électriques, notamment dans des appareils de la technique de transmission des données, dans lequel deux barrettes de renforcement superposées (2,3) en matière plastique, par exemple en résine époxy renforcées par des fibres, sont stratifiées sur une extrémité d'une feuille conductrice flexible (1), la première barrette (3) appliquée directement sur la feuille conductrice (1) comporte des perçages (8), qui établissent un contact traversant et sont pourvus de cosses à braser (9), et la seconde barrette disposée sur la première barrette comporte, aux mêmes emplacements que ceux auxquels des perçages sont prévus dans la première barrette, des évidements (6), qui possèdent un diamètre égal ou supérieur à celui des cosses à braser (9) situées sur la première barrette (3), les extrémités de contacts sont fixées dans les perçages (8), et les voies conductrices (13), situées sur la feuille conductrice (1) sont mises à nu pour l'établissement du contact, sur la face opposée de cette feuille.

2. Connecteur pour l'établissement de liaisons électriques suivant la revendication 1, caractérisé par le fait que les contacts situés dans les perçages (8) sont des broches (7) ou des cosses à braser.

3. Connecteur pour l'établissement de liaisons électriques suivant la revendication 2, caractérisé par le fait que les tiges (7) comportent, à l'une de leurs extrémités, des têtes (10), qui sont situées dans les évidements (6) de la seconde plaquette à circuits imprimés (2) et que le diamètre des perçages (8) de la première plaquette à circuits imprimés (3) est supérieur au diamètre des tiges (7), mais inférieur au diamètre des têtes (10).

4. Procédé pour insérer des broches ou des cosses à braser du connecteur suivant la revendication 2, caractérisé par le fait qu'on introduit tout d'abord dans les évidements (6) de la seconde plaquette à circuits imprimés (2), de la brasure d'étain sous la forme d'une pâte à braser, puis on introduit les tiges (7) ou les cosses à braser à partir du côté de la seconde plaquette à circuits imprimés (2), à travers les évidements (6), dans les perçages (8) de la première plaquette à circuits imprimés (3) et qu'on les fixe par brasage dans les évidements (6) au moyen d'une nouvelle fusion de la brasure à l'étain.

5. Procédé pour insérer des broches du connecteur suivant la revendication 3, caractérisé par le fait qu'on enfonce les broches (7) à partir du côté de la seconde plaquette à circuits imprimés (2) dans les perçages (8) de la première plaquette à circuits imprimés (3) jusqu'à ce que les têtes (10) viennent en butée dans les évidements (6), puis qu'on dépose une pâte à braser dans les évidements (6) et qu'on fixe fermement par brasage les tiges (7) au moyen d'une nouvelle fusion de la brasure à l'étain.
